# EUROPÄISCHE PATENTSCHRIFT

(11) **EP 2 291 866 B1**
(45) Veröffentlichungstag und Bekanntmachung des Hinweises auf die Patenterteilung: **13.05.2020**
(21) Anmeldenummer: 09772281.3
(22) Anmeldetag: 10.06.2009
(51) Int. Cl.: H01L 31/18, H01L 31/0384, H01L 31/046

(54) **VERFAHREN ZUR HERSTELLUNG VON MONOKORNMEMBRAN-BASIERTEN SOLARZELLEN**
METHOD FOR THE PRODUCTION OF SOLAR CELLS BASED ON A MONOGRAIN MEMBRANE
PROCÉDÉ DE FABRICATION DE CELLULES SOLAIRES À BASE DE MEMBRANE MONOGRAIN

(30) Priorität: 03.07.2008 DE 102008040147
(43) Veröffentlichungstag der Anmeldung: 09.03.2011
(73) Patentinhaber: Crystalsol GmbH, 1110 Wien (AT)
(72) Erfinder: MEISSNER, Dieter, 21514 Büchen (DE)
(74) Vertreter: Gille Hrabal
(86) Internationale Anmeldenummer: PCT/EP2009/057127
(87) Internationale Veröffentlichungsnummer: WO 2010/000581

(56) Entgegenhaltungen:
- EP-A1- 1 521 308
- EP-A1- 1 521 309
- FR-A- 1 372 154
- US-A- 3 522 339
- US-A- 4 521 640
- MELLIKOV E ET AL: "Monograin materials for solar cells", SOLAR ENERGY MATERIALS AND SOLAR CELLS, ELSEVIER SCIENCE PUBLISHERS, AMSTERDAM, NL, Bd. 93, Nr. 1, 10. Juni 2008 (2008-06-10), Seiten 65-68, XP025671445, ISSN: 0927-0248, DOI: DOI:10.1016/J.SOLMAT.2008.04.018 [gefunden am 2008-06-10]

## Beschreibung

Die Erfindung betrifft ein Verfahren zur Herstellung von Solarzellen umfassend die Herstellung einer Monokornmembran.

Eine Monokornmembran ist eine Membran mit darin in einer Ebene eingebetteten Körnern, Kügelchen oder Partikeln. Die Dicke der Membran entspricht dem Durchmesser der Körner, wobei mit dem Begriff Körner nachfolgend grundsätzlich auch Kügelchen oder Partikel gemeint sind, falls nicht ausdrücklich etwas anderes ausgesagt wird. In der Regel ist die Dicke der Membran kleiner als der Durchmesser der darin befindlichen Körner, so dass diese aus wenigstens einer Membranoberfläche herausragen. Die Membran besteht regelmäßig aus einem elektrisch nicht leitfähigen Binder, so zum Beispiel einem elektrisch nicht leitfähigen Polymer. Die Körner bestehen insbesondere aus einem Material, welches Strahlung und zwar insbesondere Sonnenlicht in elektrische Energie umzuwandeln vermag und/ oder Strahlung emittiert und aus elektrischer Energie generiert. In der Regel sind die Körner elektrische Halbleiter.

Monokornmembranen, die in etwa nur ein Korn dick sind, weisen verschiedene Vorteile gegenüber dickeren Membranen auf. So werden Übergangswiderstände zwischen den Körnern vermieden. Weil kein Korn ein anderes Korn abschirmt, lassen sich gute Wirkungsgrade erzielen. Außerdem wird ein günstiges Verhältnis zwischen Materialgewicht zu wirksamer Oberfläche erhalten.

Monokornmembranen nebst hieraus hergestellten Solarzellen sind beispielsweise aus der US 2007/0189956 A1 oder der US 2007/1 13888 A1 bekannt.

In der Druckschrift DE-AS 1 764 873 wird eine photoempfindliche Vorrichtung mit einer Monokornmembran beschrieben, die photoempfindliche Körner bzw. Partikel enthält. Die photoempfindlichen Körner bestehen beispielsweise aus Cadmiumsulfid, das mit 0,1 bis 0,01 Atomprozent Kupfer dotiert ist. Der Durchmesser der Körner beträgt etwa 40 µm. Die Körner werden durch einen isolierenden Binder zusammengehalten, der ein Polyurethanharz ist. Die Körner stehen gegenüber beiden Seiten der Membran in etwa gleich weit hervor. Die photoempfindliche Schicht ist etwa einen Korndurchmesser dick und wird daher als Monokornmembran oder Monopartikelmembran bezeichnet. Die Monokornmembran wird mit mindestens zwei Elektroden versehen, an denen jeweils ein Anschlussleiter befestigt ist. Um die Behinderung von einfallendem Licht zu minimieren, sind die aus Indium bestehenden, insbesondere 0,3 µm dicken Elektroden auf nur einer Seite der Schicht angebracht. An einer gegenüberliegenden Seite befindet sich eine vorzugsweise 100 Angström dicke Hilfselektrode, die ebenfalls aus Indium besteht. Die Monokornmembran mit angebrachten Elektroden und Hilfselektroden kann in Kunststoff eingebettet sein.

Die Druckschrift US 3522339 A offenbart ein Verfahren für die Herstellung einer Monokornmembran. Die Körner bestehen aus halbleitendem Material mit p-n-Übergängen. Auf einem Träger wird eine dünne, flüssige, beispielsweise aus Gelatine oder wasserlöslichen Sacchariden bestehende Haftschicht aufgebracht, in die die Körner geringfügig eintauchen . Die Körner werden mit einem flüssigen Binder und zwar einem Photoabdecklack überzogen. Anschließend wird der Photoabdecklack belichtet und zwar derart, dass nach Möglichkeit nur die Bereiche zwischen den Körnern unlöslich werden. Mit Hilfe eines Entwicklungsprozesses werden die unbelichteten Bereiche entfernt. Anschließend wird die Haftschicht von Teilen der Oberfläche der Körner abgewaschen. Die freigelegte Oberfläche der Körner werden mit einer beispielsweise 100 Angström dicken, durchsichtigen Elektrode, beispielsweise bestehend aus Kupfer überzogen. Die Elektrode kann mit einem durchsichtigen Epoxidharz überzogen werden, um den Aufbau zu stabilisieren. Die Haftschicht wird anschließend abgewaschen und ein ohmscher Kontakt zwischen den hervorstehenden Körnern und einer aus Indium bestehenden Schicht hergestellt.

Aus der Druckschrift US 3522339 A ist außerdem bekannt, Körner aus n-leitendem Material mit einer umhüllenden Schicht aus p-leitendem Material zu versehen., so dass zwischen dem Kern und der umhüllenden Schicht ein p-n-Übergang gebildet wird. Die Körner werden zum Teil in eine flüssige Haftschicht versenkt, wonach die Haftschicht gehärtet wird. Dann wird von den aus der Haftschicht ragenden Kornteilen die umhüllende Schicht abgeätzt. die aus der Haftschicht ragenden Körner werden mit einem härtbaren Binder bedeckt. Nach dem Härten des Binders wird die Haftschicht entfernt und mit einer durchsichtigen Elektrode kontaktiert. Die gegenüberliegende Seite wird abgeschliffen, die Körner so teilweise freigelegt und ebenfalls mit einer Elektrode kontaktiert.

Nachteilhaft müssen bei beiden Verfahren Abtragungen an zwei Seiten erfolgen, was den Arbeitsaufwand erhöht. Auch besteht daher ein erhöhtes Risiko, unvollständig abzutragen, was den Wirkungsgrad verschlechtert.

Aus der Druckschrift FR 1 372 154 ist bekannt, Körner und einen härtbaren Binder zwischen zwei Folien einzupressen, wobei sich die Spitzen der Körner in die Folien eindrücken. Es soll so eine Monokornmembran mit vorstehenden Kornbereichen erhalten werden, die frei von Binder sind. Die Körner müssen allerdings nachteilhaft einem relativ großen Druck ausgesetzt werden. Während der Herstellung tauchen die Körner zunächst vollständig in den Binder ein und werden vollständig mit dem Binder benetzt. Es kann daher nicht zuverlässig ausgeschlossen werden, dass der Binder im vorgesehen Umfang wieder von der Kornoberfläche entfernt wird. Außerdem ist mit diesem Verfahren eine kontinuierliche Herstellung nicht möglich. Es resultiert eine Membran, aus der die Körner gegenüber beiden Oberflächen in etwa gleich weit hervorstehen.

Aus der Druckschrift EP 1 521 308 A1 ist ein kugelförmiges Halbleiterbauelement zur Verwendung in Solarzellen bekannt, das einen insbesondere aus Glas bestehenden Substratkern aufweist, der wenigstens mit einer Rückkontaktschicht und einem I-III-VI-Verbindungshalbleiter beschichtet ist. Durch Vorsehen eines Substratkerns wird relativ teures Halbleitermaterial eingespart. Die Kügelchen werden auf eine Trägerschicht, die sich auf einer flexiblen Unterlage befindet, aufgetragen und in die Trägerschicht so weit hineingedrückt, dass Teile von den Kügelchen an der Unterseite der Trägerschicht austreten und gegenüberliegende Teile nicht vollständig in die Trägerschicht hineingedrückt werden. An einer Seite wird der Verbindungshalbleiter bis auf die Rückkontaktschicht abgetragen. Beide Seiten werden abschließend geeignet mit Elektroden bedeckt, wobei eine Elektrode aus transparentem Material besteht.

Die Druckschrift EP 1 521 309 A1 offenbart ergänzend ein Verfahren zur Herstellung einer elektrischen Serienverschaltung von Solarzellen mit integrierten Halbleiterkörpern. Zunächst werden ein oder mehrere elektrisch leitende Körper in eine isolierende Trägerschicht gebracht, wobei die leitenden Körper auf wenigstens einer Seite der Trägerschicht aus der Oberfläche der Trägerschicht herausragen und so durch die leitenden Körper eine Trennlinie gebildet wird. Es werden halbleitende Körner oder Kugeln in die isolierende Trägerschicht so gebracht, dass diese wenigstens auf einer Seite der Trägerschicht herausragen. Auf einer Seite der Trägerschicht werden Teile der halbleitenden Körner abgetragen. Auf die Seite mit den abgetragenen Körnern wird eine Rückkontaktschicht aufgetragen. Auf der anderen Seite wird eine Frontkontaktschicht aufgetragen. In den beiden Kontaktschichten werden Trennschnitte so vorgenommen, dass die gewünschte Serienverschaltung erreicht wird. Darüberhinaus ist es schwierig zu verhindern, dass Kontakte zu den leitfähigen Bereichen bestehen. Hierzu müssen in der Praxis vor dem Einbringen der Kugeln oder Körner Strukturen erzeugt werden, die eine Positionierung aller Teilchen erlauben.

Der vorgenannte Stand der Technik weist den Nachteil auf, dass das Einbringen der Halbleiter und der leitenden Körper in der Praxis nur schwierig umgesetzt werden kann. Da die halbleitenden Körner in einen Träger hineingedrückt werden müssen, muss ein relativ großer Druck aufgewendet werden, der die Körner beschädigen könnte.

Aus der Druckschrift US 4,521,640 ist bekannt, halbleitende Partikel in Kunststofffolien einzubetten und an zwei Seiten elektrisch zu kontaktieren.

Die aus dem genannten Stand der Technik bekannten Merkmale können einzeln oder in Kombination mit den Merkmalen der vorliegenden Erfindung kombiniert werden, soweit nachfolgend keine gegenteilige Angabe gemacht wird.

Aus der Druckschrift MELLIKOV E ET AL: "Monograin materials for solar cells", SOLAR ENERGY MATERIALS AND SOLAR CELLS, ELSEVIER SCIENCE PUBLICHERS, AMSTERDAM, NL, Bd. 93, Nr. 1, 10. Juni 2008, Seiten 65-68, XP025671445, ISSN: 0927-0248, DOI: 10.1016/J.SOLMAT.2008.04.018 geht ein Verfahren zur Herstellung einer Solarzelle hervor, welches die Herstellung einer Monokornmembran umfasst.

Mit der vorliegenden Erfindung wird das Ziel verfolgt, Solarzellen verbessert herstellen zu können.

Die Aufgabe der Erfindung wird durch ein Verfahren mit den Merkmalen des ersten Anspruchs gelöst.

Zur Lösung der Aufgabe wird zunächst eine aus einem Binder bestehende, horizontal ausgerichtete Schicht bereitgestellt. Der Binder ist im Unterschied zum Stand der Technik, der aus der Druckschrift EP 1 521 309 A1 bekannt ist, auf einer Trägerschicht bereitgestellt, die von einer Rolle abgewickelt wird. Der Binder ist noch nicht ausgehärtet bzw. vernetzt, so dass der Binder flüssig oder zumindest zähflüssig ist. Der Binder stellt also keine Trägerschicht dar. Er befindet sich stattdessen auf einer Trägerschicht, die von einer Rolle abgewickelt wird. In die Schicht werden Körner lediglich teilweise in die Schicht gebracht und zwar durch eine Oberfläche der Schicht hindurch in die Schicht hinein. Körner teilweise einzubringen bedeutet, dass nach dem teilweisen Einbringen nur ein Teil eines jeden Korns in die Schicht eintaucht und folglich ein Bereich des Korns oberhalb der Oberfläche der Schicht verbleibt. Hierdurch wird erreicht, dass der Bereich des Korns, der oberhalb der Oberfläche eines Binders verbleibt, zuverlässig nicht mit einem Binder benetzt wird. Anschließend wird der Binder beispielsweise durch Aushärten oder Vernetzen verfestigt. Es liegt nun eine Monokornmembran mit an einer Seite vorstehenden Körnern vor, deren Oberfläche mit Sicherheit weder mit Binder oder Binderresten noch mit sonstigen Kleb- oder Haftstoffen oder Klebstoffresten versehen ist. Dieses Verfahren kann problemlos kontinuierlich durchgeführt werden. Der Träger besteht dann aus einer Bahn, die von einer Walze oder Rolle abgewickelt wird. Auf diese Rolle wird zunächst kontinuierlich der Binder aufgetragen, so zum Beispiel aufgedruckt. Im Anschluss daran werden die Körner oder Kugeln kontinuierlich aufgetragen, so zum Beispiel aufgestreut. Beispielsweise durch eine nachfolgende Walze werden die Körner in den Binder hineingedrückt oder aber die Körner sinken selbständig in den Binder hinein. Die gewünschte Monokornmembran kann so kontinuierlich und automatisiert hergestellt werden.

Werden die Körner nur teilweise in den Binder gebracht, so dass die Körner teilweise herausragen, so müssen auf dieser Seite keinerlei Maßnahmen zur Entfernung von Binder oder Klebstoffen durchgeführt werden, die stets mit dem Risiko verbunden sind, dass eine Entfernung nur unvollständig gelingt und außerdem einen zusätzlichen Arbeitsschritt bedeuten. Vor allem wenn die Körner bzw. Kugeln keine glatte Oberfläche aufweisen (was beim eingangs genannten Stand der Technik stets der Fall ist), kann beim Stand der Technik regelmäßig nicht erreicht werden, dass sämtliche freigelegten Oberflächen der Körner keinerlei Binderreste oder Klebstoffreste mehr aufweisen. Da Körner zunächst lediglich auf die Oberfläche der aus einem Binder bestehenden Schicht aufgebracht werden und dann entweder ein Teil eines Korns teilweise einsinkt oder unter Anwendung eines leichten Drucks sanft teilweise hineingedrückt wird, kann der Binder die Körner dann nicht vollständig benetzten. Damit ist gewährleistet, dass diese freiliegenden Oberflächen der Körner mit Sicherheit nicht mit Binderresten und dergleichen unerwünscht versehen sind.

Auch ist es erfindungsgemäß nicht erforderlich, Körner oder Kugeln einem hohen Druck auszusetzen, was die Körner beschädigen könnte. Es ist ferner nicht notwendig zu verhindern, dass die Körner oder Kugeln mit den in der Schicht befindlichen leitfähigen Bereichen in Kontakt kommen oder in diese eingedrückt werden.

Abgesehen von adhäsionsbedingten Abweichungen, die angrenzend an die Körner auftreten, verläuft die Oberfläche des Binders herstellungsbedingt grundsätzlich geradlinig. Auch die Unterseite des Binders weist grundsätzlich einen geradlinigen Verlauf auf, da ein Träger für die aus dem Binder bestehende Schicht in der Regel eben ist. Insgesamt ergibt sich so eine Geometrie und Gestaltung einer Monokornmembran mit vorstehenden Kornoberflächen, die niemals in Kontakt mit dem Binder gelangt sind und daher keine Binderreste aufweisen.

Um eine Solarzelle aus einer Monokornmembran herstellen zu können, bestehen die Körner aus einem Material, welches Sonnenlicht in elektrische Energie umzuwandeln vermag. Der vorstehende Teil der Körner ist für die Herstellung einer Solarzelle mit einer Schicht versehen, mit der ein p-n-Übergang bereitgestellt wird, nachfolgend p-n-Beschichtung genannt. Der Kern des Korn besteht dann insbesondere aus einem n-leitenden Material, der mit einer p-leitenden Schicht umhüllt wird. Grundsätzlich kann zwar auch die äußere Schicht n-leitend sein und sich auf einem p-leitenden Bereich befinden. Grundsätzlich sollte Sonnenlicht oder allgemein elektromagnetische Strahlung zuerst auf die p-leitende Schicht auftreffen, um zu leistungsfähigen Solarzellen zu gelangen. Um Strom geeignet aus den Körnen abführen zu können, besteht der Binder aus einem elektrisch nicht leitfähigem Material. Es resultiert eine Monokornmembran, in der die Körner teilweise in einen elektrischen Isolator eingebettet sind. Gegenüber einer Oberfläche des Isolators stehen die Körner zum Teil hervor, indem die Körner nur teilweise in den Binder gebracht worden sind. Der vorstehende Teil der Körner ist mit einer p-n-Beschichtung versehen. Die p-n-Beschichtung setzt sich darüber hinaus herstellungsbedingt in den Isolator hinein fort.

Anstelle einer pn-Beschichtung kann beispielsweise ein Schottky-Kontakt oder eine andere Barriere für einen Ladungsträger vorgesehen sein, um so Strom mit Hilfe einer elektromagnetischen Strahlung erzeugen zu können.

In einer Ausführungsform sind die Körner ganz oder im Wesentlichen einkristallin, vorzugsweise polykristallin beschaffen. Der kristalline Aufbau ermöglicht große Wirkungsgrade. Polykristalline Körner lassen sich vergleichsweise preiswert herstellen und sind daher besonders zu bevorzugen. Es kann lediglich der Kern eines Korns kristallin beschaffen sein.

Die Körner bestehen insbesondere aus Si, Ge, GaAs, CdTe, CdSe, CulnSe₂, InP, PbS, SbS oder CuZnSnSSe. Die pn-Übergänge liegen beispielsweise aufgrund einer geeigneten Dotierung oder durch eine geeignet veränderte Zusammensetzung vor. So kann Silizium oder Germanium im Inneren mit Bor dotiert sein und an der Oberfläche mit Arsen oder Phosphor, um einen pn-Übergang zu erhalten. Die jeweilige Dotierungskonzentration liegt typischerweise bei 10¹⁵ bis 10²⁰ Dotierungsatome pro cm³. Im Fall von GaAs liegt Ga im Inneren und As in der äußeren Schicht im Überschuss vor, um so einen pn-Übergang zu erhalten. Entsprechendes gilt für die weiteren genannten Verbindungshalbleiter.

Im Fall von CuZnSnSSe wird auf die Oberfläche n-leitendes CdSu aufgetragen, um so Körner mit pn-Beschichtung aus preiswerten Materialien fertigen zu können.

Der Durchmesser der Körner liegt insbesondere bei 5 µm bis 5 mm, vorzugsweise bei 10 bis 50 µm. Die Beschichtung der Körner zur Bildung eines pn-Übergangs ist insbesondere 100 nm bis 2 µm dick. Soweit Körner gegenüber einer Binderoberfläche hervorstehen, stehen diese insbesondere um 1 bis 5 µm hervor.

Die Körner können einen beispielsweise aus Glas bestehenden Kern umfassen, um teure Halbleitermaterialien einzusparen. Allerdings erhöht sich dadurch der ohmsche Widerstand, den der erzeugte Strom überwinden muss.

Wird erfindungsgemäß aus einer solchen Monokornmembran eine Solarzelle hergestellt, bei dem zwei Seiten der Körner zu kontaktieren sind, so werden die Körner so in den Isolator bzw. in den elektrisch nicht-leitfähigen Binder eingebracht, dass diese die gegenüberliegende Oberfläche des Isolators zumindest erreichen.

Befindet sich der Isolator auf einer weichen Klebstoffschicht oder einer vergleichbar weichen Schicht, so reichen die Körner bevorzugt etwas in die weiche Schicht hinein bzw. sind in die weiche Schicht hineingedrückt worden. Nach Entfernen der weichen Schicht werden die freigelegten Körner vorzugsweise poliert oder dergleichen, so dass die p-n-Beschichtung genannte Umhüllung in diesem Bereich entfernt wird. Da die Umhüllung des Korns entfernt wird, wird zugleich sichergestellt, dass keine Binderreste oder Reste der weichen Schicht auf der so freigelegten Oberfläche nachteilhaft zurückgeblieben sind.

Grundsätzlich befindet sich dieser freigelegte Bereich der Körner aufgrund des Abtragens der p-n-Beschichtung in einer Ebene oder zumindest im Wesentlichen in einer Ebene mit der angrenzenden Oberfläche des Binders. Körner stehen an dieser Seite der aus dem Binder gebildeten Schicht dann nicht hervor.

In einer Ausführungsform der Erfindung wird das Material des Binders so gewählt, dass dieses härter als das Material der Körner ist. Es wird so erreicht, dass ein Polieren zur Folge hat, dass das Material der Körner schneller abgetragen wird als der Binder. Dies stellt besonders zuverlässig sicher, dass die Körner im gewünschten Umfang abgetragen werden. In der Regel sind dann die Körner im polierten Bereich gegenüber der Oberfläche des Binders nach Innen hohlkugelartig gewölbt, weil die Körner schneller abgetragen werden als der Binder.

In einer Ausführungsform der Erfindung kann die Klebstoffschicht durch Flüssigkeit gelöst werden. Besonders bevorzugt ist die Klebstoffschicht wasserlöslich, um den Klebstoff umweltfreundlich und preiswert abwaschen und so leicht entfernen zu können. Die Klebstoffschicht kann unmittelbar auf einem Träger aufgebracht sein. Um die Klebstoffschicht auch im verfestigten Zustand zuverlässig leicht ablösen zu können, kann sich zwischen dem Träger und der Klebstoffschicht eine Haftschicht befinden.

Um kontinuierlich Monokornmembranen für Solarzellen fertigen zu können, wird eine Bahn auf dem Träger hergestellt, die aus sich abwechselnden Abschnitten besteht. Die Abschnitte erstrecken sich entlang der Bahn und verlaufen daher parallel zum bahnenförmigen Träger bahn- oder streifenförmig. Ein erster Abschnitt umfasst die vorgenannte Schicht mit dem elektrisch nicht leitfähigen Binder nebst daraus vorstehenden Körnern. Ein zweiter daran angrenzender Abschnitt umfasst eine Schicht oder Bereiche aus elektrisch leitfähigem Material. Diese beiden Abschnitte, Schichten bzw. Bereiche wechseln sich ein- oder mehrmals ab und legen so die Gesamtbreite der Bahn fest. Aus unten genannten Gründen ermöglicht dieser Aufbau ein kontinuierliches Herstellungsverfahren für elektrisch seriell miteinander verbundene Solarzellen. Eine kostengünstige Fertigung im großtechnischen Maßstab wird dadurch ermöglicht. Es resultiert eine Monokornmembran mit Abschnitten bzw. Bereichen, die durch einen elektrischen Isolator mit darin befindlichen Körnern gebildet werden, wobei diese Abschnitte durch bahnen- oder streifenförmige elektrisch leitfähige Bereiche voneinander getrennt sind. Ein Bereich ist elektrisch leitfähig im Sinne der Erfindung, wenn durch den Bereich hindurch ein elektrischer Stromtransport möglich ist. Es genügt, wenn der elektrisch leitfähige Bereich durch eine Vielzahl von elektrisch leitfähigen Teilchen gebildet wird, die untereinander nicht elektrisch miteinander verbunden sein müssen. Die Teilchen müssen lediglich einen Stromtransport von einem Rückkontakt zu einem Frontkontakt bzw. vorderen Kontakt von Solarzellen ermöglichen und in diesem Sinne den Stromtransport durch den Bereich hindurch ermöglichen. Es kann sich um Drähte handeln, die den elektrisch leitfähigen Bereich bilden. Als elektrisch leitfähiges Material eignet sich beispielsweise Metall oder Graphit.

Der Träger besteht insbesondere aus einer Aluminiumfolie, Stahlfolie, Polyesterfolie oder Teflonfolie. Die Dicke der Folie beträgt insbesondere einige 10 bis einige 100 µm, so zum Beispiel 100 µm. Die Folie ist so biegsam, dass diese von einer Rolle zwecks kontinuierlicher Fertigung abgewickelt werden kann. Entsprechend wird die Dicke der Folie ausgewählt. Aus Metall bestehende Trägerfolien sind zu bevorzugen, da dann die Trägerfolie hinreichend verzugsfrei ist, um kontinuierlich in unten beschriebener Weise fertigen zu können.

Da die elektrisch leitfähigen Bereiche lediglich einem Stromtransport dienen, sind diese vorzugsweise schmal ausgestaltet, um so den Platzbedarf vorteilhaft zu minimieren. Ein elektrisch leitfähiger Bereich ist im Sinne der Erfindung schmal ausgestaltet, wenn die Breite des Bereichs schmaler ist als die Breite der angrenzenden elektrisch isolierenden Schichten mit den darin befindlichen Körnern.

Um eine Solarzelle zu optimieren, ist die Schicht aus elektrisch nicht leitfähigem Material mit den vorstehenden Körnern also um ein Mehrfaches breiter als die angrenzenden Bereiche mit dem elektrisch leitfähigen Material. Der Strom erzeugende Bereich ist dann groß im Vergleich zu den Bereichen, die lediglich der Durchleitung von Strom von einem Rückkontakt zu einem Frontkontakt dienen.

In einer Ausführungsform der Erfindung besteht der elektrisch leitfähige Bereich aus einem elektrisch leitfähigen Binder. Diese Ausführungsform hat den Vorteil, dass der elektrisch leitfähige Bereich zusammen mit dem elektrisch nicht-leitfähigem Binder in einem Fertigungsschritt auf dem Träger aufgetragen werden kann, beispielsweise besonders einfach und genau durch ein Druckverfahren.

Um auf einfache Weise zu gewährleisten, dass ein jedes Korn nur zum Teil in die aus einem Binder bestehende Schicht hinein gelangt, befindet sich die Schicht oberhalb eines aus einem Feststoff bestehenden Trägers, in den die Körner nicht einsinken können. Der Abstand zwischen der Oberfläche des Trägers und der Oberfläche der aus einem Binder bestehenden Schicht ist kleiner als der Durchmesser der Körner, die nur teilweise in die aus einem Binder bestehende Schicht eingebracht werden. Da die Körner in den Träger nicht eindringen können, wird so mit Sicherheit erreicht, dass Körner nicht vollständig in die aus einem Binder bestehende Schicht einsinken.

In einer Ausgestaltung des Verfahrens umfasst dieses die folgenden Schritte:
Auf eine klebrige und/ oder mit Klebstoff versehene Oberfläche eines bahnenförmigen Trägers wird aneinandergrenzend ein elektrisch nicht leitfähiger Binder und ein elektrisch leitfähiger Binder bahnen- oder streifenförmig aufgetragen. Anschließend werden die Körner, die mit einer Beschichtung zur Bildung eines p-n-Übergangs versehen sind ("pn-Beschichtung" genannt), mit jeweils einem Teilbereich eines jeden Korns in die elektrisch nicht leitfähigen Binder gebracht, so dass die Körner zumindest bis an die klebrige und/ oder mit Klebstoff versehene Oberfläche des bahnenförmigen Trägers heran reichen, diese klebrigen oder Klebstoffschichten also berühren. Es ist unschädlich, wenn die Körner auch in die elektrisch leitfähigen Bereiche gelangen. Die Körner können also gleichmäßig auf die Binder aufgestreut werden. Dies vereinfacht das Verfahren erheblich, da nicht auf eine räumliche Verteilung der Partikel geachtet werden muss. Es können auch keine Störungen dadurch auftreten, dass die elektrisch leitfähigen Bereiche aus einem Feststoff bestehen, in den die Körner nicht einsinken können.

Die Oberflächen der so hergestellten elektrisch nicht leitfähigen sowie leitfähigen Schichten bzw. Bahnen werden abschnittsweise bahnenförmig mit einem transparenten, elektrisch leitfähigen Material so bedeckt, dass jeder bahnenförmige Abschnitt mit nur einer darunter liegenden, elektrisch leitfähigen Schicht elektrisch verbunden ist und umgekehrt jede darunter liegende elektrisch leitfähige Schicht mit nur einem bahnenförmigen, elektrisch leitfähigen, transparenten Abschnitt elektrisch verbunden ist. Anschließend wird der Träger nebst klebriger Oberfläche oder Klebstoffschicht zusammen mit der unmittelbar angrenzenden p-n-Beschichtung entfernt und zwar insbesondere durch Abwaschen. Die so freigelegte Oberfläche wird bahnenförmig sowie abschnittsweise mit elektrisch leitfähigem Material bedeckt, so dass jeder bahnenförmige Abschnitt mit nur einer darunter liegenden elektrisch leitfähigen Schicht elektrisch verbunden ist und umgekehrt jede darunter liegende elektrisch leitfähige Schicht mit nur einem bahnenförmigen, elektrisch leitfähigen Abschnitt elektrisch verbunden ist, so dass einzelne Solarzellen elektrisch seriell miteinander verbunden werden. Zwei über eine elektrisch leitfähige Mittelschicht miteinander verbundene äußere elektrisch leitfähige Abschnitte bedecken dann unterschiedliche Schichten mit den vorstehenden Körnern. Die elektrisch leitfähigen Abschnitte stellen Front- und Rückkontakte der Solarzellen dar.

Nach Abschluss dieser Schritte liegt bereits ein funktionsfähiges Solarmodul vor, welches mehrere, elektrisch in Serie geschaltete Solarzellen umfasst.

Die elektrisch nicht leitfähigen Bereiche mit den darin befindlichen Körnern sind vorzugsweise 3 bis 20 mm breit, um so auf der einen Seite eine hinreichend breite Schicht zur Verfügung zu haben, in der elektrischer Strom erzeugt wird, und auf der anderen Seite nicht zu große Verluste aufgrund von ohmschen Widerständen in Kauf nehmen zu müssen. Die elektrisch leitfähigen Bereiche sind vorzugsweise nicht bereiter als 1 mm, da diese nicht zur Stromerzeugung beitragen, sondern nur Teil der elektrischen Serienschaltung sind.

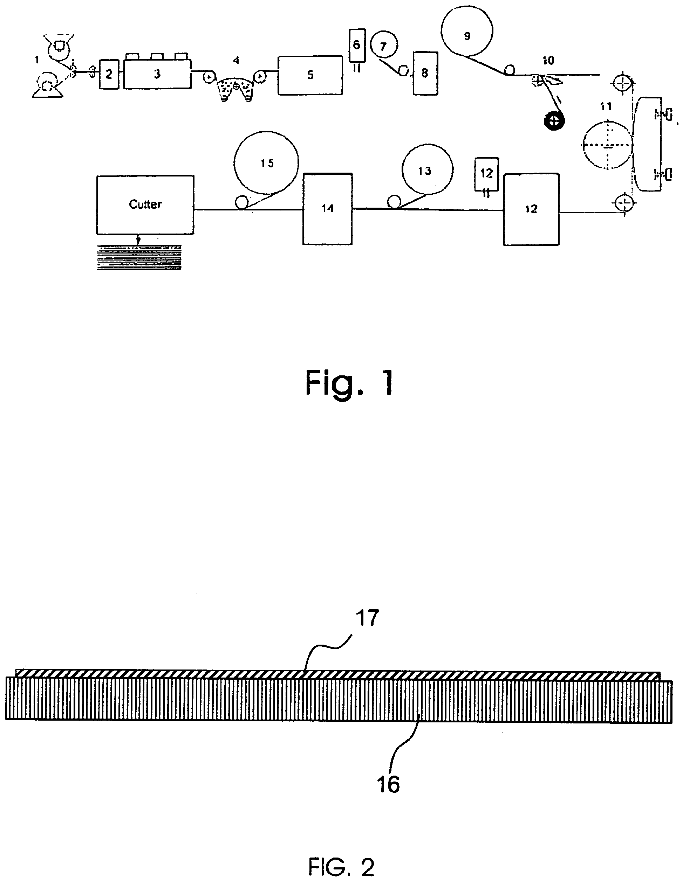

Figur 1 vermittelt einen Überblick über die Abfolge der einzelnen Verfahrensschritte. Die Anlage für die Herstellung umfasst zunächst Mittel 1 für die Zuführung einer beispielsweise aus Metall oder einem Polymer bestehenden Trägerfolie in eine nachfolgende Bearbeitungsstation 2 hinein. Die Trägerfolie, insbesondere bestehend aus 100 µm dickem Stahl, wird von einer Rolle abgerollt und über Führungswalzen der Bearbeitungsstation 2 zugeführt. Bevorzugt umfassen die Zuführungsmittel 1 zwei Walzen, um möglichst schnell die Trägerfolie einer zweiten Walze zuführen zu können, sobald die Trägerfolie einer ersten Walze aufgebraucht ist.

Die typischerweise 0,05 bis 0,5 mm dicke und typischerweise 70 bis 120 cm breite Trägerfolie wird waagerecht in die Bearbeitungsstation 2 hinein transportiert. In der Bearbeitungsstation 2 wird eine aus Klebstoff bestehende Schicht, nachfolgend Klebeschicht genannt, auf die Oberseite der Trägerfolie 16 aufgetragen. Die aufgetragene Klebeschicht ist beispielsweise 1 bis 2 µm dick. Figur 2 zeigt einen Schnitt entlang der Breite der Folie 16 mit der darauf befindlichen Klebeschicht 17. Die Klebeschicht kann beispielsweise durch ein Druckverfahren aufgebracht worden sein.

Die Klebeschicht besteht insbesondere aus Gummiarabikum oder aus einem konventionellen Fotokleber. Mit dem Klebstoff wird zunächst nur das Ziel verfolgt, dass die aufgetragenen nachfolgenden Schichten haften und vom Träger wieder gelöst werden können. Entsprechend ist der Klebstoff der Klebstoffschicht auszuwählen. Von Vorteil ist es, wenn die Klebstoffschicht jederzeit hinreichend weich ist, so dass Körner ohne großen Kraftaufwand ein wenig in die Klebstoffschicht hineingedrückt werden können.

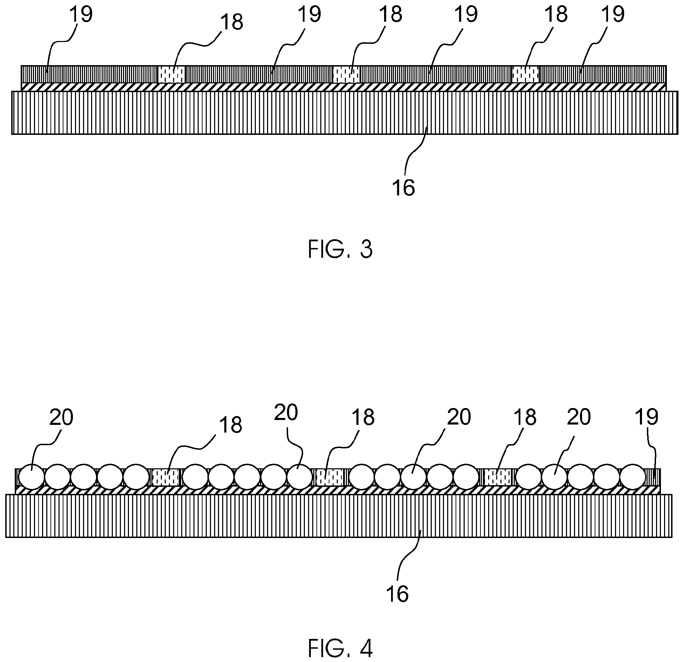

Nach dem Auftragen der Klebeschicht 17 gelangt die beschichtete Trägerfolie zu einer Bearbeitungsstation 3, in der bahnenförmig elektrisch leitfähige Polymere 18 und nicht-leitfähige Polymere bzw. Binder 19 aneinandergrenzend aufgetragen werden und zwar insbesondere durch ein Druckverfahren. Die bahnen- oder streifenförmigen Abschnitte erstrecken sich senkrecht zur Breite der Trägerfolie, also entlang Trägerfolienbahn. Figur 3 zeigt die aufgetragenen Abschnitte 18 und 19 im Schnitt. Die elektrisch leitfähigen Polymerbahnen 18 werden beispielsweise als graphithaltige Suspensionen aufgetragen. Die aufgetragenen Bahnen 19 können beispielsweise aus Epoxidharzen bestehen. Die Dicke der aufgetragenen Polymerbahnen beträgt typischerweise 5 bis 20 µm, vorzugsweise wenigstens 20 µm. Die Breite einer elektrisch nicht-leitfähigen Bahn 19 ist vorzugsweise wesentlich bereiter als die Breite einer elektrisch leitfähigen Bahn 18 und zwar insbesondere wenigstens doppelt so breit, besonders bevorzugt wenigstens dreimal so breit, um so große aktive Flächen im Verhältnis zu den elektrisch leitfähigen Abschnitten 18 zu erhalten.

Geeignete, elektrisch leitfähige Polymere bestehen insbesondere aus Polyacetylen, Polyanilin oder aber es handelt sich um Komposite mit elektrisch leitfähigen Teilchen. Geeignete elektrisch nicht-leitende Binder sind Polyesterharze oder Binder auf Basis von Polyesterharzen. Geeignet elektrisch nicht leitfähige Binder sind kommerziell erhältlich, so zum Beispiel unter der Bezeichnung Epikote 828, 838 und 1001.

In die noch weichen, bahnenförmigen, elektrisch nicht leitfähigen Schichten 19 werden nun photoaktive Partikel oder Körner 20 eingebracht. Dies geschieht in einer in Figur 1 gezeigten Bearbeitungsstation 4. Die photoaktiven Körner können Sonnenenergie in elektrische Energie umwandeln. Die Durchmesser der Körner sind größer als die Dicke der elektrisch nicht leitfähigen Polymerbahnen 19 einschließlich der Klebeschicht 17, so dass die eingebrachten Körner nicht vollständig in die Polymerbahnen eintauchen. Die Partikel 20 können aufgestreut werden und anschließend schwerkraftbedingt in die Polymerbahn einsinken, bis das Sinken durch die Klebeschicht 17 oder den Träger 16 gestoppt wird. Die Partikel können erforderlichenfalls oder zur Beschleunigung des Vorgangs in die Potymerbahnen 19 hineingedrückt werden. Es ist unkritisch, wenn Partikel 20 die elektrisch leitfähigen Bahnen 18 kontaktieren. Der Durchmesser der Partikel, Körner bzw. Kügelchen 20 ist größer als die Dicke der der Schichten 19, so zum Beispiel 1 mm.

Die photoaktiven Partikel 20 sind bereits so beschichtet, dass ein p-n-Übergang vorliegt.

Figur 4 verdeutlicht im Schnitt den Zustand, dass die Körner 20 in die Bahnen 19 teilweise gebracht sind und die Klebeschicht 17 kontaktieren. Zwar sind die Körner 20 exakt kreisförmig dargestellt, was aber in der Regel nicht der Fall ist.

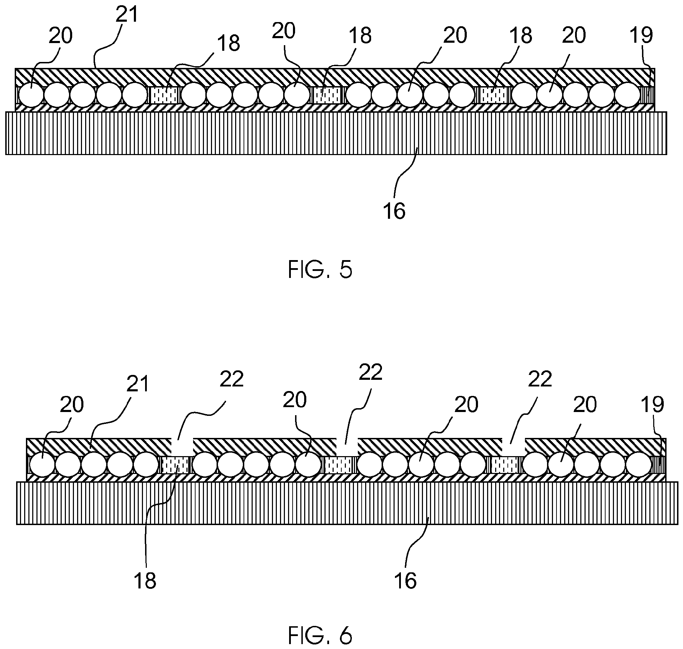

In einer sich anschließenden Station 5 wird auf die Polymerbahnen 19 mit den vorstehenden Partikeln 20 eine transparente, elektrisch leitfähige Schicht 21 aufgetragen, beispielsweise bestehend aus Zinkoxid oder aus InSnO₃ bzw. allgemein aus ITO. Die Auftragung kann durch eine Drucktechnik oder durch Sputtern erfolgen. Wie Figur 5 zeigt, kontaktiert die elektrisch leitfähige, transparente Beschichtung 21 elektrisch sowohl die Partikel 20 als auch die elektrisch leitfähigen Bahnen 18. Der Auftrag kann unmittelbar strukturiert erfolgen oder zunächst vollflächig sowohl die elektrisch leitfähigen Schichten 18 als auch die elektrisch nicht leitfähigen Schichten 19 bedecken.

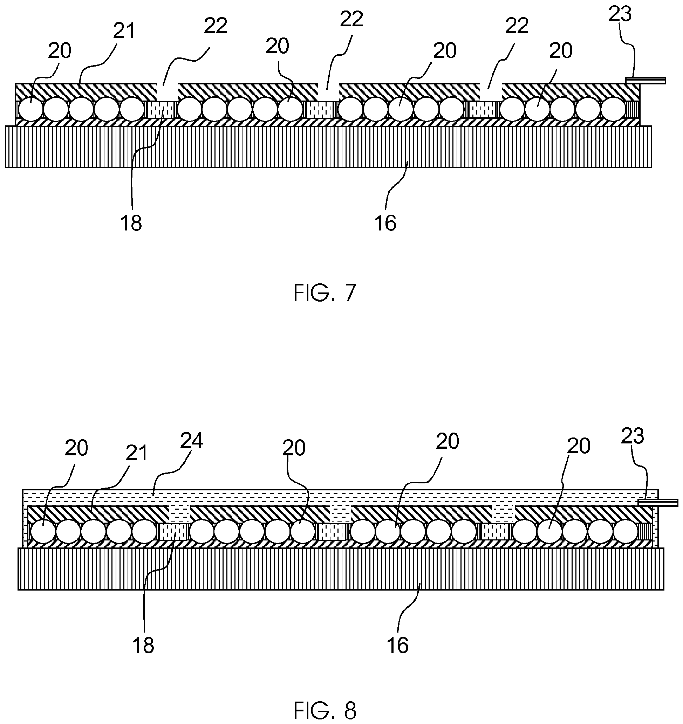

Mittels einer Bearbeitungsstation 6 wird die transparente Schicht 21 wie in Figur 6 gezeigt strukturiert, falls nicht bereits zuvor in dieser Weise strukturiert aufgetragen wurde. Dies geschieht beispielsweise genau und kostengünstig mit einem Laser. Die so erhaltenen Ausnehmungen 22 trennen die transparente Schicht 21 in einzelne Bahnen und zwar derart, dass jede transparente Bahn seitlich mit nur noch mit einer elektrisch leitfähigen Polymerbahn 18 elektrisch verbunden ist und umgekehrt jede elektrisch leitfähige Polymerbahn 18 mit nur einer elektrisch leitfähigen transparenten Bahn 21 elektrisch verbunden ist. Ein elektrisch leitfähiger, beispielsweise aus Aluminium bestehender Streifen 23 wird an einer Seite in einer Station 7 mit einer äußeren transparenten Bahn 21 elektrisch verbunden, wie durch Figur 7 verdeutlicht wird. Der Streifen 23 wird beispielsweise mit einem elektrisch leitfähigen Klebstoff entsprechend aufgeklebt oder aufgelötet.

In einer Station 8 wird die Oberfläche mit einer transparenten, elektrisch nicht leitfähigen Klebeschicht 24 versehen, die die Voraussetzungen schafft, um eine nachfolgende Schutzschicht leicht geeignet aufbringen zu können. Die Klebeschicht kann beispielsweise aus PVA (Polyvinylacetat) bestehen. Die Klebeschicht 24 kann auch seitliche Bereiche bedecken, wie durch Figur 8 verdeutlicht wird. Die Klebeschicht füllt Zwischenräume aus und sorgt so für eine ebene Oberfläche.

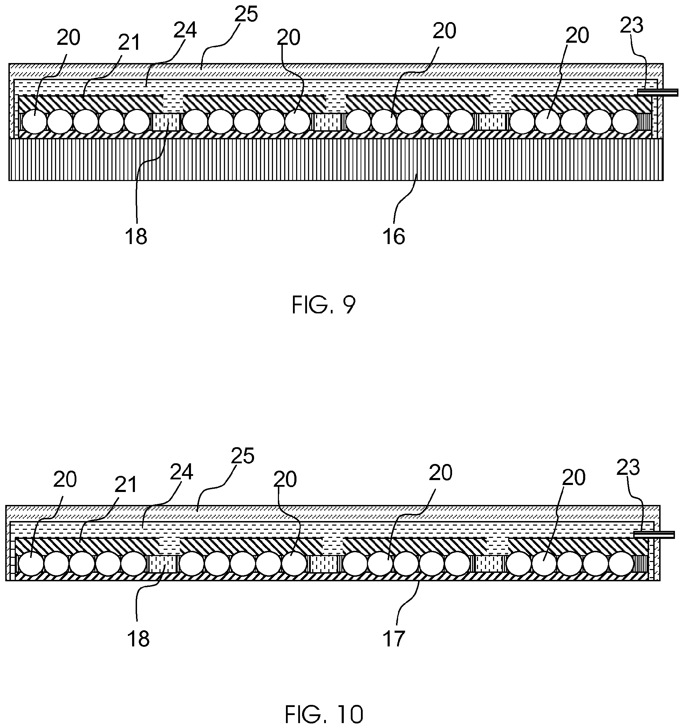

Um die Solarzelle zu kapseln, wird eine weitere, in Figur 9 gezeigte Schutzschicht 25 beispielsweise auflaminiert. Diese Schutzschicht ist durch die Klebeschicht 24 mit den Solarzellen fest verbunden. Die Schutzschicht 25 schützt insbesondere gegen Feuchtigkeit und Sauerstoff. Die Schutzschicht besteht insbesondere aus einer flexiblen Hochbarrierefolie, um die Schutzschicht problemlos kontinuierlich aufbringen zu können. Grundsätzlich ist auch Glas geeignet, um die Solarzellen geeignet vor Sauerstoff und Feuchtigkeit zu schützen.

In einer Station 10 wird die Trägerfolie 16 entfernt, was insbesondere dann leicht möglich ist, wenn der Klebstoff 17 noch weich, also nicht ausgehärtet oder vollständig vernetzt ist. Es liegt nun der in Figur 10 im Schnitt dargestellte Aufbau vor.

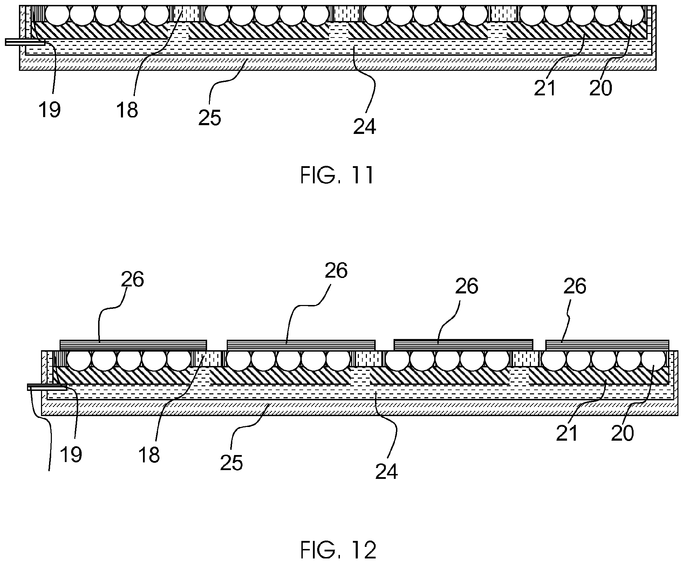

In einer nächsten Station 11 wird der Klebstoff 17 entfernt, beispielsweise durch Abwaschen und/ oder Abbürsten. Außerdem werden die p-n-Beschichtungen der so freigelegten Bereiche der Partikel bzw. Körner 20 beispielsweise durch Polieren entfernt, um einen ohmschen Kontakt zu ermöglichen. Außerdem wird die Bahn nun nach unten umgelenkt und dann entgegengesetzt horizontal weiter geleitet, um so die frei gelegten, polierten Kornoberflächen umzudrehen und leicht beschichten zu können. Vor Erreichen der nächsten Station 12 befindet sich die Bahn in dem in Figur 11 gezeigten Zustand.

In der Station 12 werden nun weitere elektrische Kontakte 26 beispielsweise strukturiert schichtförmig aufgedruckt. Es kann aber auch zunächst eine elektrisch leitfähige Schicht vollflächig aufgetragen und im Anschluss mit einem Laser strukturiert werden. Zwischen den Kernen der Partikel 20 und den Kontakten 26 liegt nun allein ein Ohmscher Kontakt vor. Die Kontakte 26 vervollständigen eine elektrische serielle Verbindung zwischen den einzelnen Abschnitten, die durch eine elektrisch nicht leitfähige Polymerschicht 19 nebst darin teilweise eingebetteten Partikeln 20 gebildet werden. Ein jeder elektrischer Kontakt 26 ist daher wiederum mit nur einer elektrisch leitfähigen, streifenförmigen Schicht 18 elektrisch verbunden und bedeckt darüber hinaus genau eine seitlich angrenzende Schicht, die durch elektrisch nicht leitendes Polymer 19 und Partikel 20 gebildet wird. Die Kontakte 21 und 26 bedecken die bahnenförmigen Schichten, die durch elektrisch nicht leitendes Polymer 19 und Partikel 20 gebildet werden, möglichst vollständig, wie Figur 12 zeigt. Allerdings verbleibt in der Regel ein kleiner Randbereich, der von den Kontakten 26 nicht erfasst wird. So wird sichergestellt, dass keine weitere elektrische Verbindung zu einer zweiten streifenförmigen, elektrisch leitfähigen Schicht 18 vorliegt. Aus gleichem Grund werden auch die elektrisch leitfähigen, streifenförmigen Schichten 18 in der Regel durch oberhalb und unterhalb angrenzende Kontakte 21 und 26 nur teilweise überdeckt.

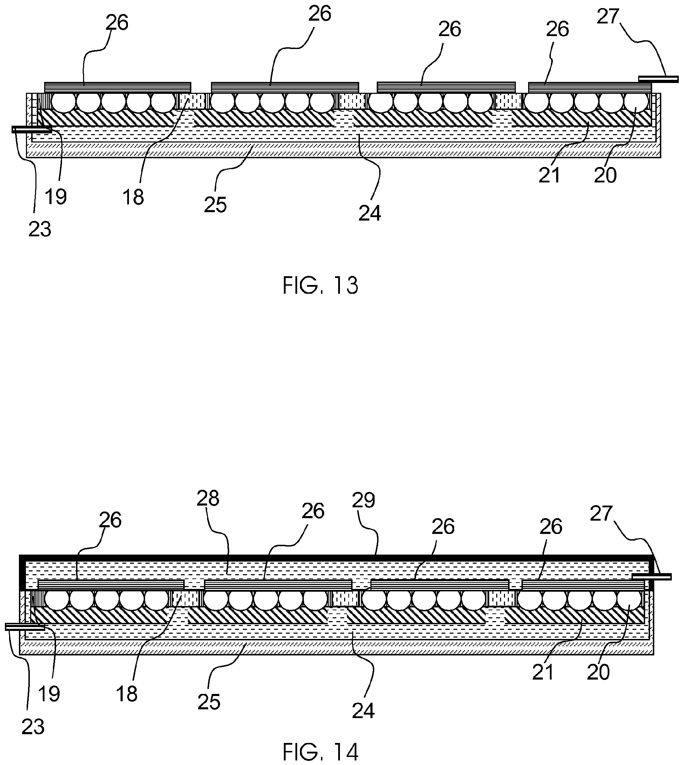

In einer sich anschließenden Station 13 wird nun ein weiterer elektrisch leitfähiger Streifen 27 angebracht, so dass dieser seitlich hervorsteht. Dieser Streifen 27 besteht beispielsweise aus Aluminium oder einem anderen Metall wie zum Beispiel Kupfer und befindet sich auf der Seite, die der Seite mit dem bereits angebrachten, elektrisch leitfähigem Streifen 23 gegenüberliegt. Die Anbringung kann in der bereits genannten Weise erfolgen. Die resultierende Situation wird in Figur 13 im Schnitt dargestellt.

In der nächsten Bearbeitungsstation 14 wird nun die Oberfläche beispielsweise durch einen Klebstoff 28 gekapselt und in einer sich anschließenden Bearbeitungsstation 15 vorzugsweise mit einer Aluminiumfolie 29 ergänzend geschützt. Die Folie wird so ausgesucht, dass diese insbesondere vor Feuchtigkeit und Wasser schützt. Sie muss nicht transparent sein. Spiegelt die Folie, so zum Beispiel eine aus Aluminium bestehende Folie, so kann eine elektromagnetische Strahlung in Richtung Solarzelle zurück reflektiert werden, um so den Wirkungsgrad zu steigern.

Abschließend wird die Bahn in gewünschte Größen in einer Schneidstation (Cutter) geteilt.

Die Fertigung kann vollständig kontinuierlich erfolgen und endet mit fertigen Solarzellen gewünschter Größe. Die seitlich vorstehenden, elektrisch leitfähigen Streifen 23 und 27 ermöglichen leicht das Zusammenschalten von mehreren so hergestellten Solarzellen oder aber das Verbinden mit einem elektrischen Verbraucher.

## Patentansprüche

1. Verfahren zur Herstellung von Solarzellen umfassend die Herstellung einer Monokornmembran mit den Schritten:
Bereitstellen einer aus einem elektrisch nicht leitfähigen Binder bestehenden Schicht (19) auf einer Trägerschicht (16);
teilweises Einbringen von Körnen (20) durch eine Oberfläche der aus einem Binder bestehenden Schicht (19) hindurch in die Schicht (19) hinein;
wobei die Körner (20) aus einem Material bestehen, welches Sonnenlicht in elektrische Energie umzuwandeln vermag;
Verfestigen des elektrisch nicht leitfähigen Binders, in den die Körner eingebracht worden sind, **dadurch gekennzeichnet, dass** die Trägerfolie (16) von einer Rolle abgewickelt wird, eine Bahn kontinuierlich auf der Trägerschicht (16) hergestellt wird, die aus sich abwechselnden Abschnitten besteht, wobei ein erster Abschnitt die vorgenannte Schicht (19) mit dem elektrisch nicht leitfähigen Binder nebst daraus vorstehenden Körnern (20) umfasst und ein zweiter daran angrenzender bahnen-oder streifenförmiger, elektrisch leitfähiger Abschnitt eine Schicht (18) oder Bereiche aus elektrisch leitfähigem Material umfasst und sich diese beiden Abschnitte mehrmals abwechsein,
die Oberfläche der so hergestellten elektrisch nicht leitfähigen und elektrisch leitfähigen Abschnitte wird abschnittsweise bahnenförmig mit einem transparenten, elektrisch leitfähigen Material (21) so bedeckt, dass jeder bahnenförmige Abschnitt mit nur einem
darunter liegenden elektrisch leitfähigen Abschnitt verbunden ist;
anschließend wird der Träger (16) entfernt und die so freigelegte Oberfläche wird bahnenförmig sowie abschnittsweise mit elektrisch leitfähigem Material (26) bedeckt, so dass jeder bahnenförmige Abschnitt mit nur einem darunter liegenden elektrisch leitfähigen Abschnitt verbunden ist, so dass einzelne Solarzellen elektrisch seriell miteinander verbunden werden.

2. Verfahren nach Anspruch 1, **dadurch gekennzeichnet, dass** zumindest der aus der Schicht vorstehende Teil der Körner einen p-n-Übergang umfasst, so dass die Schicht (19) ein elektrischer Isolator ist, wobei die Körner (20) insbesondere kristallin beschaffen sind und/ oder aus einem elektrischen Halbleiter bestehen.

3. Verfahren nach dem vorhergehenden Anspruch, bei dem die Schichten (18) oder Bereiche aus elektrisch leitfähigem Material um ein Mehrfaches schmaler als die elektrisch nicht leitfähigen Schichten (19) sind.

4. Verfahren nach einem der vorhergehenden Ansprüche, bei dem die aus einem Binder bestehende Schicht (19) über einen aus einem Feststoff bestehenden Träger (16) gebracht wird und so die aus einem Binder bestehenden Schicht (19) bereitgestellt wird, wobei der Abstand zwischen obere Oberfläche des Trägers (16) und obere Oberfläche der Schicht (19) so eingestellt wird, dass dieser Abstand kleiner ist als der Durchmesser der Körner (20), die in diese Schicht (19) teilweise hineingebracht werden.

## Claims

1. Method for the production of solar cells, comprising the production of a monograin membrane with the steps:
providing a layer (19) consisting of an electrically non-conductive binder on a carrier layer (16);
partially introducing of grains (20) through a surface of the layer (19) consisting of a binder into the layer (19);
wherein the grains (20) consist of a material which is capable of converting sunlight into electrical energy;
solidifying the electrically non-conductive binder into which the grains have been introduced,
**characterized in that**
the carrier film (16) is unwound from a roll, a web which consists of alternating sections is continuously produced on the carrier layer (16), wherein a first section comprises the aforementioned layer (19) with the electrically non-conductive binder together with grains (20) protruding therefrom and a second web or strip-shaped electrically conductive section adjacent thereto comprises a layer (18) or areas of electrically conductive material and these two sections alternate several times,
the surface of the electrically non-conductive and electrically conductive sections thus produced is covered in sections in a web-like manner with a transparent, electrically conductive material (21) in such a way that each web-like section is connected to only one electrically conductive section underneath;
subsequently the carrier (16) is removed and the surface thus exposed is covered with electrically conductive material (26) in a web-like manner as well as in sections, in such a way that each web-like section is connected to only one electrically conductive section underneath, so that individual solar cells are electrically serially connected with each other.

2. Method according to claim 1, **characterized in that** at least the part of the grains protruding from the layer comprises a p-n transition, so that the layer (19) is an electrical insulator, wherein the grains (20) are in particular crystalline and/or consist of an electrical semiconductor.

3. Method according to the preceding claim, wherein the layers (18) or regions of electrically conductive material are several times narrower than the electrically non-conductive layers (19).

4. Method according to one of the preceding claims, wherein the layer (19) consisting of a binder is placed over a carrier (16) consisting of a solid material and thus the layer (19) consisting of a binder is provided, wherein the distance between upper surface of the carrier (16) and upper surface of the layer (19) is adjusted so that this distance is smaller than the diameter of the grains (20) which are partially introduced into this layer (19).

## Revendications

1. Procédé de fabrication de cellules solaires comprenant la fabrication d'une membrane monograine comprenant les étapes consistant à:
prévoir une couche (19) constituée d'un liant non conducteur de l'électricité sur une couche de support (16) ;
introduire partiellement des grains (20) à travers une surface de la couche (19) constituée d'un liant dans la couche (19) ;
dans lequel les grains (20) sont constitués d'un matériau capable de convertir la lumière du soleil en énergie électrique ;
solidifier le liant non conducteur de l'électricité, dans lequel les grains ont été introduits,
caractérisé en ce
le film porteur (16) est déroulé d'un rouleau, une bande est fabriquée en continu sur la couche porteuse (16), qui se compose de sections alternées, une première section comprenant la couche (19) susmentionnée avec le liant électriquement non conducteur ainsi que des grains (20) qui faisant saillie de celle-ci, et une deuxième section électriquement conductrice en forme de bande ou de ruban qui lui est adjacente comprend une couche (18) ou des régions de matériau électriquement conducteur, et ces deux sections alternent plusieurs fois,
la surface des sections électriquement non conductrices et électriquement conductrices ainsi fabriquées est recouverte par sections en forme de bande avec un matériau transparent électriquement conducteur (21) de telle sorte que chaque section en forme de bande est reliée à une seule section électriquement conductrice sous-jacente ;
le support (16) est ensuite enlevé et la surface ainsi exposée est recouverte en forme de bande et par sections avec un matériau électriquement conducteur (26) de telle sorte que chaque section en forme de band est reliée à une seule section électriquement conductrice sous-jacente, de sorte que les cellules solaires individuelles sont électriquement connectées en série les unes avec les autres.

2. Procédé selon la revendication 1, **caractérisé en ce qu'**au moins la partie des grains faisant saillie de la couche comprend une jonction p-n, de sorte que la couche (19) est un isolant électrique, les grains (20) étant en particulier de nature cristalline et/ou constitués d'un semi-conducteur électrique.

3. Procédé selon la revendication précédente, dans laquelle les couches (18) ou les régions de matériau électriquement conducteur sont plusieurs fois plus étroites que les couches électriquement non conductrices (19).

4. Procédé selon l'une des revendications précédentes, dans lequel la couche (19) constituée d'un liant est placée sur un support (16) constitué d'un matériau solide et ainsi créant la couche (19) constituée d'un liant, la distance entre la surface supérieure du support (16) et la surface supérieure de la couche (19) étant réglée de telle sorte que cette distance soit inférieure au diamètre des grains (20) qui sont partiellement introduits dans cette couche (19).
